# EUROPÄISCHE PATENTSCHRIFT

(11) **EP 3 323 155 B1**
(45) Veröffentlichungstag und Bekanntmachung des Hinweises auf die Patenterteilung: **15.05.2019**
(21) Anmeldenummer: 16731112.5
(22) Anmeldetag: 17.06.2016
(51) Int. Cl.: H01L 35/30

(54) **THERMOELEKTRISCHER WÄRMETAUSCHER**
THERMOELECTRIC HEAT EXCHANGER
ÉCHANGEUR DE CHALEUR THERMOÉLECTRIQUE

(30) Priorität: 15.07.2015 DE 102015213295
(43) Veröffentlichungstag der Anmeldung: 23.05.2018
(73) Patentinhaber: MAHLE International GmbH, 70376 Stuttgart (DE)
(72) Erfinder: GRÜNWALD, Jürgen, 71638 Ludwigsburg (DE); HENEKA, Christian, 76227 Karlsruhe (DE)
(74) Vertreter: BRP Renaud & Partner mbB Rechtsanwälte Patentanwälte Steuerberater
(86) Internationale Anmeldenummer: PCT/EP2016/064043
(87) Internationale Veröffentlichungsnummer: WO 2017/009000

(56) Entgegenhaltungen:
- EP-A2- 2 282 356
- JP-A- 2000 286 459
- JP-A- 2006 156 818
- US-A1- 2007 220 902
- US-B1- 6 226 994

## Beschreibung

Die vorliegende Erfindung betrifft einen thermoelektrischen Wärmetauscher zum Temperieren eines Fluids, insbesondere für ein Kraftfahrzeug, mit einem Peltier-Element. Die Erfindung betrifft des Weiteren ein solches Peltier-Element.

Zum Temperieren von Fluiden, insbesondere von Gasen, kommen gewöhnlich Wärmetauscher zum Einsatz. Derartige Wärmetauscher erlauben es hierbei, das Fluid zu erwärmen und/oder zu kühlen. Hierzu können solche Wärmetauscher Temperierelemente aufweisen.

Bekannt ist es, als solche Temperierelemente elektrisch dissipative Heizelemente vorzusehen, die beim Durchfließen eines elektrischen Stroms dissipative Wärme erzeugen. Ein solches Heizelement ist aus der WO 92/06570 A bekannt. Das Heizelement ist hierbei als ein Kaltleiter bzw. ein Positive Temperature Coefficient-Heizelement (PTC-Heizelement) ausgebildet und kommt zum Heizen eines Luftstroms zum Einsatz.

Nachteilig bei solchen dissipativen Heizelementen ist, dass sie, insbesondere bei geringen zur Verfügung stehenden elektrischen Ressourcen, kein ausreichendes Heizen erlauben und/oder einen zu hohen Ressourcenverbrauch haben.

Aus dem Stand der Technik ist es auch bekannt, zum Temperieren eines Fluids thermoelektrische Temperierelemente einzusetzen. Der Einsatz eines solchen thermoelektrischen Heizelements in einem Wärmetauscher ist aus der DE 10 2009 058 673 A1 und der EP 2 518 424 A1 bekannt. Hierbei kommt jeweils ein Peltier-Element zum Einsatz, das durch eine entsprechende Schaltung und Anlage einer elektrischen Spannung eine Kaltseite und eine Warmseite aufweist. Eine entsprechende Anordnung des Peltier-Elements erlaubt es, außer dem durch den Temperaturunterschied bedingten Wärmeübertrag zwischen dem Fluid und einem anderen Fluid einen durch das Peltier-Element erzielen Wärmeübertrag zu realisieren, so dass der Gesamtwärmeübertrag vergrößert wird. Solche Peltier-Elemente weisen eine Vielzahl von unterschiedlich dotierten Halbleitern auf, welche miteinander verschaltet sind. Um einen Kurzschluss zwischen den Halbleitern zu vermeiden, werden die Halbleiter beidseitig durch eine elektrisch isolierende Beschichtung und/oder eine elektrisch isolierende Platte elektrisch isoliert. Eine solche elektrische Isolierung stellt dabei regelmäßig eine thermische Barriere dar, die einen thermischen Austausch des Peltier-Elements verschlechtert. Da die elektrischen Isolierungen ferner auf den in Wärmeflussrichtung gegenüberliegenden Seiten des Peltier-Elements angeordnet sind, ist der Wärmeaustausch zwischen dem Peltier-Element und dem zu temperierenden Fluid oder Gegenstand erschwert.

Solche Peltier-Elemente sind zudem starr ausgebildet. Im Betrieb des Peltier-Elements kommt es zu einem Temperaturunterschied innerhalb des Peltier-Elements, der zu thermischen Spannungen innerhalb des Peltier-Elements führt. Diese thermischen Spannungen können dabei zu einer Beschädigung der elektrischen Isolierung des Peltier-Elements führen, ebenso zur Beschädigung der elektrischen Verbindungen zwischen den Halbleitern, was die Funktion des Peltier-Elements negativ beeinträchtigen, insbesondere zum Ausfall des Peltier-Elements führen, kann.

US 2007/0220902 A1 zeigt einen Wärmetauscher mit einem Peltierelement wobei das Peltierelement einen ersten Träger zum Tragen von Halbleitern des Peltierelements aufweist. Das Peltierelement weist zudem einen zweiten Träger und einen dritter Träger auf, wobei in diesen Trägern Wärmeaustauschelemente gehalten sind, welche jeweils über Elektroden elektrisch mit den Halbleitern kontaktiert sind.

Die vorliegende Erfindung beschäftigt sich daher mit dem Problem, für einen ein Peltier-Element aufweisenden thermoelektrischen Wärmetauscher zum Temperieren eines Fluids sowie für ein solches Peltier-Element eine verbesserte oder zumindest andere Ausführungsform anzugeben, die sich insbesondere durch eine verbesserte Effizienz und/oder Beständigkeit auszeichnet.

Dieses Problem wird erfindungsgemäß durch die Gegenstände der unabhängigen Ansprüche gelöst. Vorteilhafte Ausführungsformen sind Gegenstand der abhängigen Ansprüche.

Die vorliegende Erfindung beruht auf dem allgemeinen Gedanken, bei einem ein Peltier-Element aufweisenden thermoelektrischen Wärmetauscher zum Temperieren eines durch einen Strömungsraum strömenden Fluids, wenigstens einen Halbleiter des Peltier-Elements elektrisch verbindenden Leiter zumindest bereichsweise im Strömungsraum anzuordnen, so dass er insbesondere dem strömenden Fluid direkt ausgesetzt ist. Hierdurch kann der Leiter sowohl zum elektrischen Verbinden der Halbleiter als auch zum Wärmeaustausch zwischen dem Fluid und dem Peltier-Element eingesetzt werden. In der Folge kommt es zu einem verbesserten Wärmeaustausch zwischen dem Fluid und dem Peltier-Element, so dass die Effizienz des Wärmetauschers verbessert wird. Zudem kommt es durch das Anordnen eines solchen Leiters im Strömungsraum zu geringeren thermischen Spannungen und/oder einem verbesserten Abbau thermischer Spannungen innerhalb des Peltier-Elements, so dass entsprechende Beschädigungen des Peltier-Elements verhindert oder zumindest reduziert werden und eine Beständigkeit und/oder Lebensdauer des Wärmetauschers somit verbessert wird.

Dem Erfindungsgedanken entsprechend weist der thermoelektrische Wärmetauscher also den Strömungsraum auf, der vom zu temperierenden Fluid durchströmbar ist. Das Peltier-Element dient dem Temperieren des Fluids und weist eine Vielzahl von abwechselnd angeordneten p-dotierten P-Halbleitern und n-dotierten N-Halbleitern auf. Die elektrische Verbindung der Halbleiter erfolgt durch besagte Leiter, welche durch eine Verbindungsstruktur und eine Kontaktierungsstruktur realisiert sind. Hierbei sind die Halbleiter auf ihrer dem Strömungsraum zugewandten Seite durch die Verbindungsstruktur elektrisch kontaktiert und auf ihrer vom Strömungsraum abgewandten Seite durch die Kontaktierungsstruktur elektrisch kontaktiert. Zum elektrischen Kontaktieren der Halbleiter weist die Verbindungsstruktur Verbindungselemente auf, welche jeweils zwei solche Halbleiter elektrisch kontaktieren und gegeneinander elektrisch isoliert sind. Die Kontaktierungsstruktur weist zum elektrischen Kontaktieren der Halbleiter Kontaktelemente auf, welche jeweils zwei solche Halbleiter elektrisch kontaktieren und gegeneinander elektrisch isoliert sind. Dabei ist erfindungsgemäß vorgesehen, dass zumindest ein solches Verbindungselement im Strömungsraum angeordnet ist.

Die Halbleiter des Peltier-Elements sind vorzugsweise mittels der Verbindungsstruktur und der Kontaktierungsstruktur in Reihe geschaltet. Vorstellbar ist es jedoch auch zumindest zwei der Halbleiter parallel zu schalten.

Durch die erfindungsgemäße Lösung kann auf eine elektrisch isolierende Schicht und/oder elektrisch isolierende Platte auf der dem Strömungsraum zugewandten Seite des Peltier-Elements verzichtet werden, wobei bevorzugte Varianten ohne eine solche elektrisch isolierende Schicht bzw. Platte ausgebildet sind. Hierdurch wird eine durch eine solche elektrisch isolierende Schicht bzw. Platte bedingte thermische Barriere zwischen dem Peltier-Element und dem Fluid erheblich reduziert, so dass es zu einem verbesserten Wärmeaustausch zwischen dem Fluid und dem Peltier-Element und somit zu einer verbesserten Effizienz des Wärmetauschers kommt. Zudem führt der Verzicht auf solche isolierende Schichten zu einer vereinfachten und kostengünstigeren Herstellung des Peltier-Elements bzw. des Wärmetauschers. Darüber hinaus kann hierdurch das Gewicht des Peltier-Elements bzw. des Wärmetausches reduziert werden.

Der erfindungsgemäße Wärmetauscher kann in einer beliebigen Anwendung zum Temperieren eines solchen Fluids eingesetzt werden. Vorstellbar ist es insbesondere, den Wärmetauscher in einem Kraftfahrzeug einzusetzen, um ein durch das Kraftfahrzeug strömendes solches Fluid zu temperieren. Insbesondere ist es vorstellbar, den Wärmetauscher als Heizer, beispielsweise Zusatzheizer, zum Temperieren des Fluids einzusetzen. Dabei kann das Fluid insbesondere Luft sein, die einem Innenraum des Kraftfahrzeugs zugeführt wird. Folglich kommt der Wärmetauscher als eine Klimatisierungseinrichtung des Kraftfahrzeugs oder als ein Teil einer solchen Klimatisierungseinrichtung zum Einsatz.

Das zu temperierende Fluid ist vorteilhaft elektrisch nicht leitend. Hierzu sollte das zu temperierende Fluid, wenn es gasförmig ist, insbesondere die zu temperierende Luft, einen vorgegebenen Feuchtigkeitsanteil nicht überschreiten. Zum Begrenzen der Feuchtigkeit des Fluids ist es daher vorstellbar, den Wärmetauscher mit einer Entfeuchtungseinrichtung auszustatten, die das Fluid stromauf des Peltier-Elements entfeuchtet.

Selbstverständlich kann mit dem erfindungsgemäßen Wärmetauscher auch eine durch den Strömungsraum strömende Flüssigkeit temperiert werden, insbesondere sofern die Flüssigkeit elektrisch nichtleitend ist bzw. sofern die Flüssigkeit eine vorgegebene elektrische Leitfähigkeit nicht überschreitet.

Die Verbindungselemente und zumindest einer der zugehörigen Halbleiter sind vorzugsweise aneinander befestigt. Vorteilhaft sind dabei Varianten, bei denen das jeweilige Verbindungselement an beiden zugehörigen Halbleitern befestigt ist. Die Befestigung ist vorteilhat durch Verlöten des Verbindungselements mit zumindest einem der zugehörigen Halbleiter realisiert.

Bevorzugte Varianten sehen vor, dass zumindest ein solches Verbindungselement unmittelbar im Strömungsraum angeordnet ist. Das heißt insbesondere, dass das Verbindungselement zumindest im Strömungsraum keine zusätzliche elektrische Isolation aufweist und/oder mit keiner zusätzlichen elektrischen Isolierung umgeben ist. Hierdurch kann es zu einem unmittelbaren Kontakt und Wärmeaustausch zwischen dem Verbindungselement und dem Fluid kommen, wodurch die Effizienz des Wärmetauschers weiter verbessert wird. Besonders bevorzugt ist es hierbei, wenn das Verbindungselement sowohl mit dem Fluid als auch mit den zugehörigen Halbleitern in wärmetauschendem Kontakt steht.

Bei bevorzugten Ausführungsformen ist zumindest ein solches Verbindungselement der Strömung des durch den Strömungsraum strömenden Fluids ausgesetzt. Das heißt, dass das Fluid in Betrieb des Wärmetauschers am Verbindungselement entlang und/oder um das Verbindungselement strömt. Hierdurch wird der Wärmeaustausch zwischen dem Fluid und dem Verbindungselement und somit zwischen dem Fluid und dem Peltier-Element verbessert und die Effizienz des Wärmetauschers damit erhöht.

Grundsätzlich ist es vorstellbar, lediglich das Peltier-Element zum Temperieren des Fluids einzusetzen.

Vorstellbar sind auch Ausführungsformen, bei denen der Wärmetauscher einen Fluidkanal aufweist, der von einem Temperierfluid durchströmbar ist, wobei der Fluidkanal fluidisch vom Strömungsraum getrennt ist. Der Fluidkanal ist zudem auf der vom Strömungsraum abgewandten Seite der Halbleiter angeordnet, welche gegenüber dem Temperierfluid elektrisch isoliert sind. Dabei wird das Temperierfluid ebenfalls zum Temperieren des Fluids eingesetzt. Insbesondere ist es vorstellbar, das Temperierfluid zusätzlich zum Peltier-Element zum Temperieren des Fluids zu verwenden.

Vorstellbar ist es beispielsweise, die dem Fluidkanal zugewandte Seite des Peltier-Elements als eine Kaltseite des Peltier-Elements zu realisieren. In der Folge ist die dem Strömungsraum zugewandte Seite des Peltier-Elements eine Warmseite des Peltier-Elements, so dass sich der Gesamtwärmeübertrag auf das Fluid aus dem Wärmeübertrag des Temperierfluids und des Peltier-Elements zusammensetzt. Hierbei wird der Wärmetauscher vorzugsweise zum Erwärmen des Fluids eingesetzt. Die Realisierung der Kaltseite und der Warmseite des Peltier-Elements kann durch das Anlegen einer entsprechenden elektrischen Spannung an das Peltier-Element erfolgen. Dabei kann durch eine andere, insbesondere umgekehrte, Anlage der elektrischen Spannung an das Peltier-Element eine Umkehr der Kaltseite und der Warmseite des Peltier-Elements realisiert werden, insbesondere um das Fluid zu kühlen.

Das Temperierfluid kann ein beliebiges Fluid sein. Das Temperierfluid kann insbesondere eine Flüssigkeit sein. Beim Einsatz des Wärmetauschers in einem Kraftfahrzeug kann das Temperierfluid insbesondere Kühlwasser des Kraftfahrzeugs sein, das im Wärmetauscher zum Erwärmen des Fluids eingesetzt und hierdurch gekühlt wird.

Der Fluidkanal kann prinzipiell beliebig verlaufen, sofern ein Wärmeaustausch zwischen dem Fluid und dem Temperierfluid, insbesondere über das Peltier-Element, möglich ist. Vorstellbar ist es insbesondere, dass der Fluidkanal entlang des Strömungsraums verläuft.

Vorteilhafte Ausführungsformen sehen vor, dass zumindest ein solches Verbindungselement in den Strömungsraum absteht. Das heißt insbesondere, dass das Verbindungselement zumindest einen Abschnitt aufweist, der von zumindest einem der zugehörigen Halbleiter in dem Strömungsraum absteht. Hierdurch wird insbesondere eine Fläche des Verbindungselements zum Wärmeaustausch mit dem Fluid vergrößert und der Wärmeaustausch mit dem Fluid somit verbessert.

Vorstellbar ist es zudem, dass zumindest ein solches Verbindungselement vom zu temperierenden Fluid durchströmbar ist. Auch hierdurch kann ein Wärmeaustausch zwischen dem Verbindungselement und dem Fluid verbessert und die Effizienz des Wärmetauschers somit erhöht werden.

Bei bevorzugten Ausführungsformen ist zumindest ein solches Verbindungselement als ein Wärmeaustauschelement zwischen dem Fluid und den zugehörigen Halbleitern ausgebildet. Das heißt insbesondere, dass die Verbindungsstruktur eine Wärmeaustauschstruktur, beispielsweise eine Rippenstruktur, sein kann, mit der sowohl eine elektrische Verbindung zwischen den Halbleitern als auch ein Wärmeaustausch zwischen den Halbleitern und dem Fluid erfolgt. Hierdurch können die Bestandteile des Wärmetauschers reduziert werden, so dass der Wärmetauscher insgesamt einfacher und/oder kostengünstiger herstellbar ist. Zudem wird der Wärmeaustausch zwischen dem Peltier-Element und dem Fluid verbessert und die Effizienz des Wärmetauschers dadurch erhöht.

Das jeweilige Verbindungselement kann prinzipiell eine beliebige Form aufweisen, sofern es zwei solche Halbleiter elektrisch verbindet und zumindest teilweise im Strömungsraum angeordnet ist.

Vorstellbar ist es auch, zumindest ein solches Verbindungselement als eine in den Strömungsraum abstehende Rippe auszubilden. Hierdurch wird der Wärmeaustausch zwischen dem Verbindungselement und dem Fluid verbessert und die Effizienz des Wärmetauschers somit erhöht.

Bevorzugte Ausführungsformen sehen vor, dass wenigstens ein solches Verbindungselement an zumindest einem der zugehörigen Halbleiter flächig anliegt. Somit wird die wärmeübertragende Fläche zwischen dem Verbindungselement und dem zumindest einen zugehörigen Halbleiter vergrößert und der Wärmeaustausch somit verbessert. In der Folge kommt es zu einer erhöhten Effizienz des Wärmetauschers. Die flächige Anlage des Verbindungselements an zumindest einem der zugehörigen Halbleiter ist vorteilhaft auf der dem Strömungsraum zugewandten Seite des zumindest einen Halbleiters realisiert. Das heißt, dass das Verbindungselement auf der dem Strömungsraum zugewandten Seite des zumindest einen Halbleiters flächig an dem zumindest einen Halbleiter anliegt.

Die elektrische Isolierung der Verbindungselemente gegeneinander kann auf eine beliebige Weise realisiert sein.

Vorstellbar ist es, zumindest zwei solche Verbindungselemente voneinander beabstandet anzuordnen, um sie gegeneinander elektrisch zu isolieren. Die beabstandete Anordnung der Verbindungselemente hat ferner den Vorteil, dass die Verbindungselemente relativ zueinander beweglich sind, so dass sie insbesondere thermische Spannungen abbauen können. Hierdurch werden also entsprechende Beschädigungen des Peltier-Elements vermieden oder zumindest reduziert und die Beständigkeit des Wärmetauschers somit verbessert.

Vorstellbar ist es auch, zumindest zwei solche Verbindungselemente über einen elektrisch isolierenden Isolierabschnitt gegeneinander elektrisch zu isolieren, der die Verbindungselemente mechanisch miteinander verbindet. Das heißt, dass zwischen den Verbindungselementen ein solcher Isolierabschnitt angeordnet ist, der die Verbindungselemente mechanisch verbindet und elektrisch isoliert.

Vorteilhafte Varianten sehen dabei vor, dass der Isolierabschnitt zum Ausgleich thermischer Spannungen elastisch ausgebildet ist. Auch hierdurch kann die Beständigkeit des Wärmetauschers erhöht werden.

Der Isolierabschnitt kann prinzipiell aus einem beliebigen Material hergestellt sein, sofern er die zugehörigen Verbindungselemente elektrisch isoliert. Vorstellbar ist es insbesondere, einen solchen Isolierabschnitt aus Kunststoff, insbesondere aus einem Polymer herzustellen. Hierdurch kann der jeweilige Isolierabschnitt und somit der Wärmetauscher einfach und kostengünstig hergestellt werden. Zudem ist es möglich, zusätzlich zur elektrischen Isolierung besagte elastische Ausbildung des Isolierabschnitts zum Ausgleich thermischer Spannungen zu realisieren.

Vorteilhaft ist es, wenn zumindest ein solches Verbindungselement zum Ausgleich thermischer Spannungen elastisch ausgebildet ist. Die elastische Ausbildung des Verbindungselements kann dabei durch eine entsprechende Materialauswahl des Verbindungselements und/oder durch eine entsprechende Form des Verbindungselements realisiert sein.

Das jeweilige Verbindungselement kann prinzipiell aus einem beliebigen Material hergestellt sein, sofern es zwei solche Halbleiter elektrisch verbindet. Bevorzugt ist das Verbindungselement aus einem Metall oder metallhaltigem Material hergestellt. Hierdurch ist sowohl eine ausreichende elektrische Leitfähigkeit des Verbindungselements als auch ein verbesserter Wärmeaustausch des Verbindungselements gegeben.

Vorstellbar ist es insbesondere, zumindest ein solches Verbindungselement aus einem Blech herzustellen und somit als ein Blechteil zu realisieren. Hierdurch ist eine einfache und kostengünstige Herstellung des Peltier-Elements möglich.

Bevorzugt ist es, wenn zumindest zwei solche Verbindungselemente als Gleichteile ausgebildet sind, um die Herstellung des Wärmetauschers zu vereinfachen und/oder eine kostengünstige Herstellung des Wärmetauschers zu erlauben.

Auch der Wärmeaustausch zwischen dem Temperierfluid bzw. dem Fluidkanal und dem Peltier-Element kann über zumindest ein solches Kontaktelement realisiert sein. Insbesondere ist es vorstellbar, zumindest ein solches Kontaktelement in analoger Weise zu zumindest einem solchen Verbindungselement im Fluidkanal anzuordnen, so dass es zu einem, insbesondere unmittelbaren, Wärmeaustausch zwischen dem Kontaktelement und dem Temperierfluid kommt. Hierbei ist es zweckmäßig ein elektrisch nicht leitendes Temperierfluid einzusetzen. Hierbei ist es insbesondere vorstellbar, die Verbindungselemente und die Kontaktelement als Gleichteile auszubilden.

Ist das Temperierfluid elektrisch nicht leitend, so ist eine elektrische Isolierung der Halbleiter gegenüber dem Temperierfluid nicht zwingend notwendig. Ist das Temperierfluid elektrisch leitend so sind die Halbleiter vorzugsweise gegenüber dem Temperierfluid isoliert.

Entsprechendes gilt für den Fluidkanal. Das heißt, dass die Halbleiter bevorzugt gegenüber dem Fluidkanal isoliert sind, wenn der Fluidkanal aus einem elektrisch leitenden Material hergestellt ist. Demgegenüber kann eine solche Isolierung entfallen, wen der Fluidkanal aus einem elektrisch nicht leitenden Material bzw. einem elektrisch isolierenden Material hergestellt ist.

Die elektrische Isolierung des Temperierfluids gegenüber den Halbleitern kann auf einer beliebigen Weise realisiert sein. Vorstellbar ist es beispielsweise den Fluidkanal aus einem elektrisch isolierenden Material, beispielsweise aus Kunststoff herzustellen.

Alternativ oder zusätzlich ist es vorstellbar, zwischen zumindest einem solchen Halbleiter und dem Fluidkanal, insbesondere zwischen zumindest einem solchen Kontaktelement und dem Fluidkanal, eine elektrisch isolierende Isolierschicht anzuordnen. Der Einsatz einer solchen Isolierschicht erlaubt es, einen solchen Fluidkanal zu verwenden, der elektrisch leitend, insbesondere aus einem Metall, hergestellt ist. Die Verwendung eines metallischen bzw. metallhaltigen Materials für den Fluidkanal erhöht hierbei den Wärmeaustausch zwischen dem Temperierfluid und dem zumindest einen Kontaktelement, wodurch die Effizienz des Wärmetauschers erhöht wird.

Vorteilhafte Varianten sehen vor, dass zumindest ein solches Kontaktelement auf der dem Strömungsraum zugewandten Seite des Fluidkanals angeordnet und am Fluidkanal befestigt ist. Eine solche Befestigung kann dabei starr ausgebildet sein, insbesondere weil der Ausgleich thermischer Spannungen auf Seiten der Verbindungsstruktur realisiert sein kann.

Die Isolierschicht zwischen dem Kontaktelement und dem Fluidkanal kann aus einem beliebigen Material hergestellt sein. Die Isolierschicht kann insbesondere ein Dielektrikum, vorzugsweise eine Keramik sein. Die Keramik ist dabei derart ausgestaltet, dass sie einen ausreichenden Wärmeaustausch zwischen dem Fluidkanal bzw. dem Temperierfluid und dem Peltier-Element gewährleistet.

Es versteht sich, dass der Wärmetauscher auch zwei oder mehrere solche Peltier-Elemente aufweisen kann. Vorstellbar ist es insbesondere, zwei solche Peltier-Elemente gegenüberliegend anzuordnen, wobei zumindest eines der Peltier-Elemente eine solche Verbindungsstruktur mit zumindest einem solchen im Strömungsraum angeordneten Verbindungselement aufweist. Zu denken ist auch an Ausführungsformen, bei denen zumindest zwei solche Peltier-Elemente nebeneinander angeordnet sind.

Vorstellbar ist es auch den Wärmetauscher mit zwei gegenüberliegenden solchen Fluidkanälen zu versehen, durch die ein solches Temperierfluid, insbesondere das gleiche Temperierfluid, strömt.

Weist der Wärmetauscher zwei oder mehr solche Peltier-Elemente auf, ist es möglich, zumindest zwei solche Peltier-Elemente elektrisch zu verbinden, insbesondere in Reihe zu schalten.

Es versteht sich, dass zumindest ein solcher Halbleiter des Peltier-Elements zwei oder mehrere Halbleiterelemente aufweisen kann, die gleichartig dotiert sind. Das heißt, dass zumindest ein solcher P-Halbleiter zwei oder mehrere p-dotierte P-Halbleiterelemente aufweisen kann. Dementsprechend kann zumindest ein solcher N-Halbleiter zumindest zwei n-dotierte N-Halbleiterelemente aufweisen.

Es versteht sich ferner, dass neben dem Wärmetauscher auch ein solches Peltier-Element des Wärmetauschers zum Gegenstand dieser Erfindung gehört, das eine solche Verbindungsstruktur mit zumindest einem solchen Verbindungselement aufweist, das im Strömungsraum des zugehörigen Wärmetauschers angeordnet werden kann.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: einen Schnitt durch einen thermoelektrischen Wärmetauscher,
- Fig. 2: den Schnitt aus Fig. 1 bei einem anderen Ausführungsbeispiel des Wärmetauschers,
- Fig. 3: einen Schnitt durch ein Peltier-Elements des Wärmetauschers,
- Fig. 4: die Ansicht aus Fig. 3 bei einem anderen Ausführungsbeispiel der Verbindungsstruktur,
- Fig. 5: eine Innenansicht des Wärmetauschers.

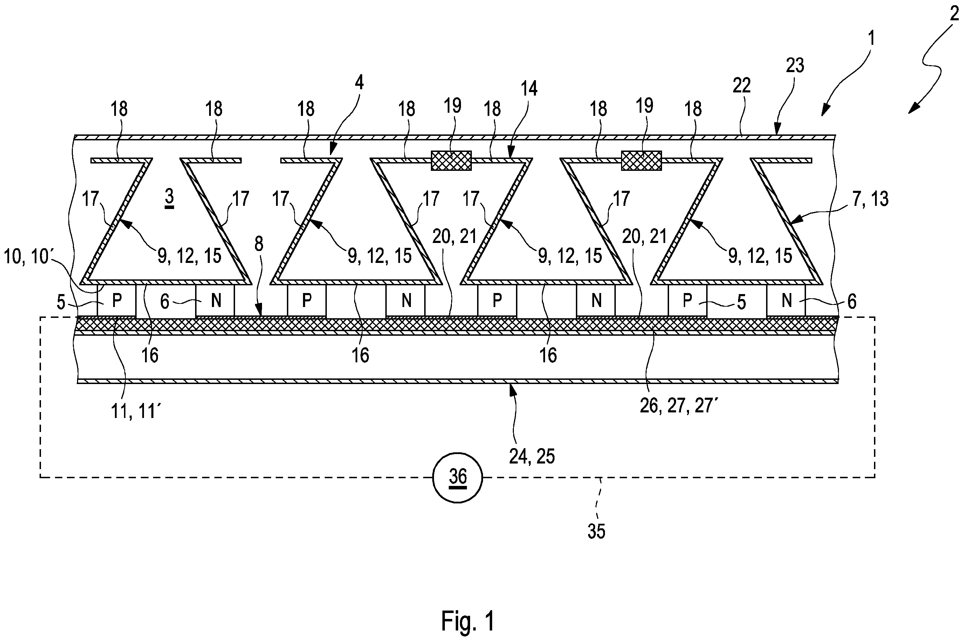

In Fig. 1 ist ein thermoelektrischer Wärmetauscher 1 eines ansonsten nicht gezeigten Kraftfahrzeugs 2 dargestellt. Der Wärmetauscher 1 weist einen Strömungsraum 3 auf, der von einem Fluid durchströmbar ist. Der Wärmetauscher 1 weist zudem ein Peltier-Element 4 auf, das eine Vielzahl von entlang des Strömungsraums 3 abwechselnd angeordneten p-dotierten P-Halbleitern 5 und n-dotierten N-Halbleitern 6 aufweist. Die Halbleiter 5, 6 sind auf ihrer dem Strömungsraum 3 zugewandten Seite mittels einer Verbindungsstruktur 7 und auf ihrer vom Strömungsraum 3 abgewandten Seite mittels einer Kontaktierungsstruktur 8 elektrisch miteinander kontaktiert und somit in Reihe geschaltet. Hierzu weist die Verbindungsstruktur 7 eine Vielzahl von Verbindungselementen 9 auf, wobei das jeweilige Verbindungselement 9 einen solchen P-Halbleiter 5 elektrisch mit dem benachbarten N-Halbleiter 6 kontaktiert. Dabei sind die Verbindungselemente 9 gegeneinander elektrisch isoliert. Die die zugehörigen Halbleiter 5, 6 elektrisch verbindenden Verbindungselemente 9 sind ferner im Strömungsraum 3 angeordnet. Hierdurch kommt es zu einem Wärmeaustausch zwischen den Verbindungselementen 9 und dem durch den Strömungsraum 3 strömenden Fluid, so dass ein Temperieren des Fluids mittels des Peltier-Elements 4 verbessert und die Effizienz des Wärmetauschers 1 erhöht wird.

Im gezeigten Beispiel bilden die dem Strömungsraum 3 zugewandten Seiten der Halbleiter 5, 6 eine erste Temperaturseite 10 des Peltier-Elements 4, wogegen die vom Strömungsraum 3 abgewandten Seiten der Halbleiter 5, 6 eine zweite Temperaturseite 11 des Peltier-Elements 4 bilden. Durch ein entsprechendes Anlegen einer elektrischen Spannung an das Peltier-Element 4, wie es in Fig. 1 mit elektrischen Verbindungen 35 und einer Spannungsquelle 36 beispielhaft gestrichelt dargestellt ist, entspricht hierbei die erste Temperaturseite 10 einer Warmseite 10' des Peltier-Elements 4, während die zweite Temperaturseite 11 einer Kaltseite 11' des Peltier-Elements 4 entspricht. Das heißt, dass die Warmseite 10' des Peltier-Elements 4 im Betrieb des Peltier-Elements 4 eine höhere Temperatur aufweist als die Kaltseite 11'. Hierdurch kann das durch den Strömungsraum 3 strömende Fluid mittels des Peltier-Elements 4 erwärmt werden. Vorstellbar ist es auch, bei einer umgekehrten Anlage der elektrischen Spannung, die Kaltseite 11' und die Warmseite 10' umzukehren, derart, dass die Kaltseite 11' dem Strömungsraum 3 zugewandt ist und dass durch den Strömungsraum 3 strömende Fluid somit gekühlt wird.

Die Verbindungselemente 9 stehen mit den zugehörigen Halbleitern 5, 6 in wärmeübertragender Verbindung, so dass sie einerseits mit dem durch den Strömungsraum 3 strömenden Fluid und andererseits mit den zugehörigen Halbleitern 5, 6 Wärme austauschen. Hierdurch kommt es zu einem verbesserten Wärmeaustausch zwischen dem Peltier-Element 4 und dem Fluid, insbesondere weil eine elektrische Isolierung des Peltier-Elements 4 auf der dem Strömungsraum 3 zugewandten Seite des Peltier-Elements 4 und somit eine entsprechende thermische Barriere entfallen kann.

Im gezeigten Ausführungsbeispiel ist das jeweilige Verbindungselement 9 in der Art einer Rippe 12 ausgebildet, die eine vergrößerte Fläche zum Wärmeaustausch mit dem Fluid zur Verfügung stellt. Das heißt, dass die Verbindungsstruktur 7 als eine Rippenstruktur 13 ausgebildet ist. Die Verbindungsstruktur 7 ist ferner aus einem metallischen Material, insbesondere aus einem Blech 14 hergestellt, um die Herstellungskosten des Wärmetauschers 1 zu reduzieren. Zudem weisen die Verbindungselemente 9 keine elektrisch isolierende Beschichtung auf, so dass sie in unmittelbarem Kontakt mit dem Fluid stehen und dementsprechend als Wärmetauschelemente 15 ausgebildet sind. Hierdurch kommt es also zu einem unmittelbaren Wärmeaustausch zwischen dem Verbindungselementen 9 und dem Fluid, wodurch die Effizienz des Wärmetauschers 1 erhöht wird.

Das jeweilige Verbindungselement 9 ist im gezeigten Beispiel und der gezeigten Ansicht symmetrisch ausgebildet und weist eine Grundseite 16 auf, von der auf gegenüberliegende Seiten einander zugeneigte Schenkel 17 abstehen, von denen wiederum voneinander weg gerichtete, parallel zur Grundseite 16 verlaufende Füße 18 abstehen. Hierdurch ergibt sich insgesamt eine omegaartige Form des jeweiligen Verbindungselements 9. Dabei liegt das jeweilige Verbindungselement 9 über die Grundseite 16 flächig an beiden zugehörigen Halbleitern 5, 6 an. Dadurch wird eine Fläche zum Wärmeaustausch zwischen dem Verbindungselement 9 und den zugehörigen Halbleitern 5, 6 vergrößert. Somit wird also der Wärmeaustausch zwischen den Halbleitern 5, 6 und den Verbindungselementen 9 und somit zwischen dem Peltier-Element 4 und dem Fluid verbessert.

Die elektrische Isolierung der Verbindungselemente 9 gegeneinander ist im gezeigten Beispiel auf zwei Arten dargestellt. Dabei können benachbarte Verbindungselemente 9 gänzlich beabstandet angeordnet und somit elektrisch gegeneinander isoliert sein. Hierzu ist die Verbindungsstruktur 7 im Bereich der Füße 18 unterbrochen. Alternativ oder zusätzlich kann zwischen benachbarten Verbindungselementen 9 ein Isolierabschnitt 19 angeordnet sein, der die Verbindungselemente 9 elektrisch isoliert und mechanisch verbindet. In Fig. 1 sind dabei zwei solche Isolierabschnitte 19 zu sehen, die jeweils zwei benachbarte Verbindungselemente 9 elektrisch isolieren und mechanisch verbinden. Die Isolierabschnitte 19 sind im gezeigten Beispiel zwischen benachbarten Füßen 18 der benachbarten Verbindungselemente 9 angeordnet und verbinden diese Füße 18 mechanisch. Die Isolierabschnitte 19 sind vorteilhaft aus Kunststoff, insbesondere aus einem Polymer, hergestellt.

Das durch den Strömungsraum 3 strömende Fluid ist vorzugsweise ein solches Fluid, das elektrisch nicht leitend ist. Dabei sollte das Fluid, wenn es gasförmig ist, einen vorgegebenen Feuchtigkeitsanteil nicht überschreiten. Zum Begrenzen der Feuchtigkeit des Fluids kann der Wärmetauscher 1 eine hier nicht gezeigte und in Strömungsrichtung des Fluids stromauf des Peltier-Elements 4 angeordnete Entfeuchtungseinrichtung zum Entfeuchten des Fluids aufweisen.

Die Verbindungselemente 9 sind durch ihre Form im Strömungsraum 3 angeordnet und stehen in den Strömungsraum 3 ab. Zudem sind die Verbindungselemente 9 vom Fluid durchströmbar. Hierdurch ist eine größere Fläche des jeweiligen Verbindungselements 9 vom Fluid angeströmt und/oder umströmt, so dass es zu einem verbesserten Wärmeaustausch zwischen den Verbindungselementen 9 und dem Fluid kommt.

Die Verbindungsstruktur 7, insbesondere die Verbindungselemente 9, sind elastisch ausgebildet, um thermische Spannungen innerhalb des Peltier-Elements 4 abzubauen. Die elastische Ausbildung der Verbindungselemente 9 ist hierbei durch die entsprechend beanstandete Anordnung der Verbindungselemente 9 und/oder ihrer Form gegeben. Zudem sind die Isolierabschnitte 19 zum Abbauen thermischer Spannungen elastisch ausgebildet. Hierdurch ist insgesamt eine relative Bewegung zwischen den Verbindungselementen 9 möglich, um besagte thermische Spannungen abzubauen.

Die Verbindungselemente 9 sind an den zugehörigen Halbleitern 5, 6 befestigt. Die Befestigung ist im gezeigten Beispiel über die Grundseiten 16 realisiert und kann starr ausgeführt sein, da der thermische Ausgleich über den Schenkeln 17 bzw. Füße 18 der Verbindungselemente 9 erfolgen kann. Hierbei ist es insbesondere vorstellbar, die Verbindungselemente 9 mit den zugehörigen Halbleitern 5 zu verlöten.

Die Kontaktstruktur 8 zum elektrischen Kontaktieren der Halbleiter 5, 6 auf der vom Strömungsraum 3 abgewandten Seite weist eine Vielzahl von Kontaktelemente 20 auf, wobei das jeweilige Kontaktelement 20 einen solchen N-Halbleiter 6 elektrisch mit einem solchen P-Halbleiter 5 kontaktiert. Dabei sind die Kontaktelemente 20 voneinander beabstandet angeordnet und somit gegeneinander elektrisch isoliert. Im gezeigten Beispiel sind die Kontaktelemente 20 als Leiterbrücken 21 ausgebildet, die eben verlaufen und aus einem metallischen oder metallhaltigen Material hergestellt sind und sich eben erstrecken. Die Kontaktelemente 20 sind ferner mit den zugehörigen Halbleitern 5, 6 verlötet.

Der Strömungsraum 3 wird auf der von der Kontaktierungsstruktur 8 abgewandten Seite der Füße 18 von einer Wand 22 begrenzt, die Bestandteil eines Gehäuses 23 sein kann.

Der Wärmetauscher 1 weist einen entlang des Strömungsraums 3 verlaufenden Fluidkanal 24 auf, der auf der von der Wand 22 abgewandten Seite des Peltier-Elements 4 angeordnet ist. Der Fluidkanal 24 ist von einem Temperierfluid, insbesondere vom Kühlwasser des Kraftfahrzeugs 2, durchströmbar. Dabei kommt das Temperierfluid zum Temperieren des durch den Strömungsraum 3 strömenden Fluids zum Einsatz. Mittels des Peltier-Elements 4 ist es dabei möglich zusätzlich zum Wärmeaustausch zwischen dem Temperierfluid und dem Fluid ein Wärmeaustausch zu realisieren und somit die Wärme zu "Pumpen". Das Peltier-Element 4 und das Temperierfluid kommen dabei vorzugsweise zum Erwärmen des Fluids zum Einsatz. Dabei bezieht die Kaltseite 1 1' des Peltier-Elements 4 die benötigte Wärme aus dem Temperierfluid und überträgt diese Wärme, bedingt durch den Peltiereffekt, verstärkt auf das Fluid, wodurch besagtes "Pumpen" der Wärme realisiert ist. Vorzugsweise weist das Temperierfluid hierzu eine höhere Temperatur auf, als das Fluid.

Im gezeigten Ausführungsbeispiel ist der Fluidkanal 24 als ein Rohr 25 ausgebildet. Dabei sind der Fluidkanal 24 und der Strömungsraum 3 fluidisch getrennt. Das Rohr 25 ist aus einem metallischen oder metallhaltigen Material hergestellt und somit elektrisch leitend. Das Peltier-Element 4, insbesondere die Halbleiter 5, 6, sind elektrisch vom Fluidkanal 24 isoliert. Hierzu ist zwischen den Halbleitern 5, 6 bzw. den Kontaktelementen 20 und dem Fluidkanal 24 eine elektrisch isolierende Isolierschicht 26 vorgesehen. Vorstellbar ist es insbesondere, die Isolierschicht 26 als eine isolierende Platte 27, insbesondere eine Keramikplatte 27', auszubilden.

Die Isolierschicht 26 und das Peltier-Element 4, insbesondere die Kontaktierungsstruktur 8, sind über die Kontaktelemente 20 aneinander befestigt, insbesondere miteinander verklebt. Zudem ist die Isolierschicht 26 mit dem Fluidkanal 24 mechanisch verbunden, insbesondere auf den Fluidkanal 24 aufgebracht. Hierdurch ist das Peltier-Element 4 am Fluidkanal 24 befestigt.

Vorstellbar ist es auch, den Fluidkanal 24, insbesondere das Rohr 25, aus einem elektrisch isolierenden Material, beispielsweise Kunststoff, herzustellen. In diesem Fall kann die Isolierschicht 26 entfallen.

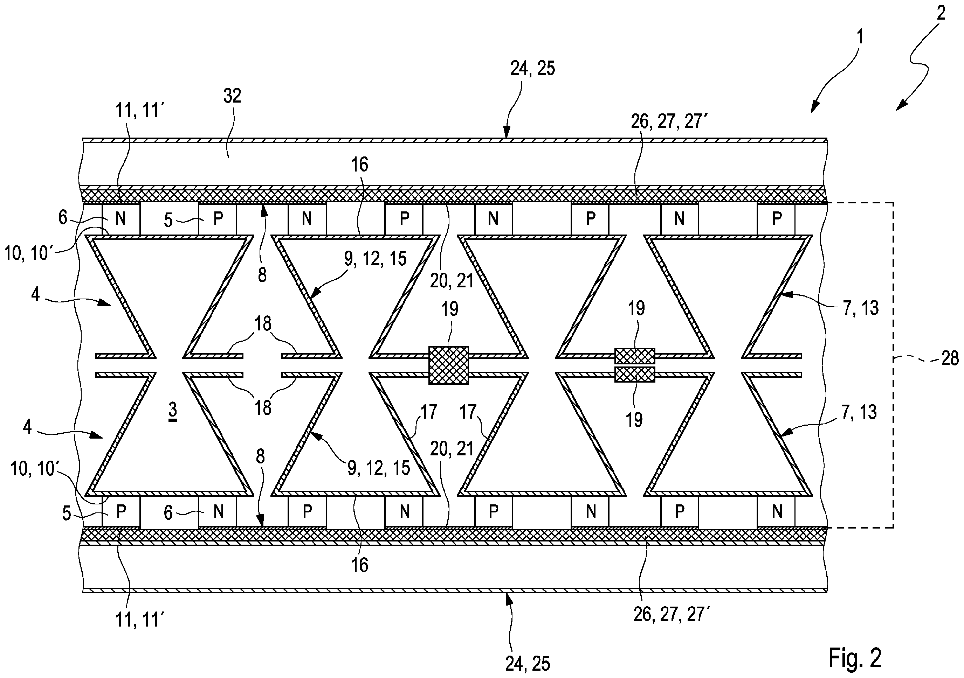

Fig. 2 zeigt ein anderes Ausführungsbeispiel des Wärmetauschers 1. Der in Fig. 2 gezeigte Wärmetauscher 1 weist zwei solche Peltier-Elemente 4 auf, die sich symmetrisch gegenüberliegend angeordnet sind. Dabei entspricht das jeweilige in Fig. 2 gezeigte Peltier-Element 4 im Wesentlichen dem Peltier-Element 4 aus Fig. 1. Die Peltier-Elemente 4 sind derart gegenüberliegend angeordnet, dass sich die Füße 18 der zugehörigen Verbindungselemente 9 der Verbindungsstrukturen 7 gegenüberliegen. Dabei wird der Strömungsraum 3 an gegenüberliegenden Seiten durch einen solchen Fluidkanal 24 bzw. eine solche Isolierschicht 26 begrenzt. Das heißt, dass der Wärmetauscher 1 in Fig. 2 zwei solche, gegenüberliegende Fluidkanäle 24 aufweist, durch die jeweils ein Temperierfluid, insbesondere das gleiche Temperaturfluid, beispielsweise Kühlwasser des zugehörigen Kraftfahrzeugs 2, strömt. Im gezeigten Beispiel wird mittels der Peltier-Elemente 4 Wärme aus dem jeweiligen Temperierfluid abgezogen und auf ein höheres Niveau gepumpt und dem Fluid zugeführt.

Die Verbindungselemente 9 der Verbindungsstrukturen 7 sind gegeneinander elektrisch isoliert. Dies erfolgt durch eine beabstandete Anordnung der Verbindungselemente 9 der Verbindungsstrukturen 7. Alternativ oder zusätzlich kann zwischen den Verbindungselementen ein solcher Isolierabschnitt 19 vorgesehen sein. Dabei ist es vorstellbar, wie in Fig. 2 mittig dargestellt, benachbarte Verbindungselemente 9 beider Peltier-Elemente 4 über einen solchen gemeinsamen Isolierabschnitt 19 elektrisch zu isolieren. Vorstellbar ist es auch, bei benachbart angeordneten Verbindungselementen 9 der Peltier-Elemente 4 jeweils einen separaten solchen Isolierabschnitt 19 vorzusehen.

Die Peltier-Elemente 4 können, wie mit einer gestrichelten Linie 28 angedeutet, in Reihe geschaltet sein, wobei im gezeigten Beispiel hierzu ein N-Halbleiter 6 des einen Peltier-Elements 4 mit einem P-Halbleiter 5 des anderen Peltier-Elements 4 in elektrischem Kontakt steht.

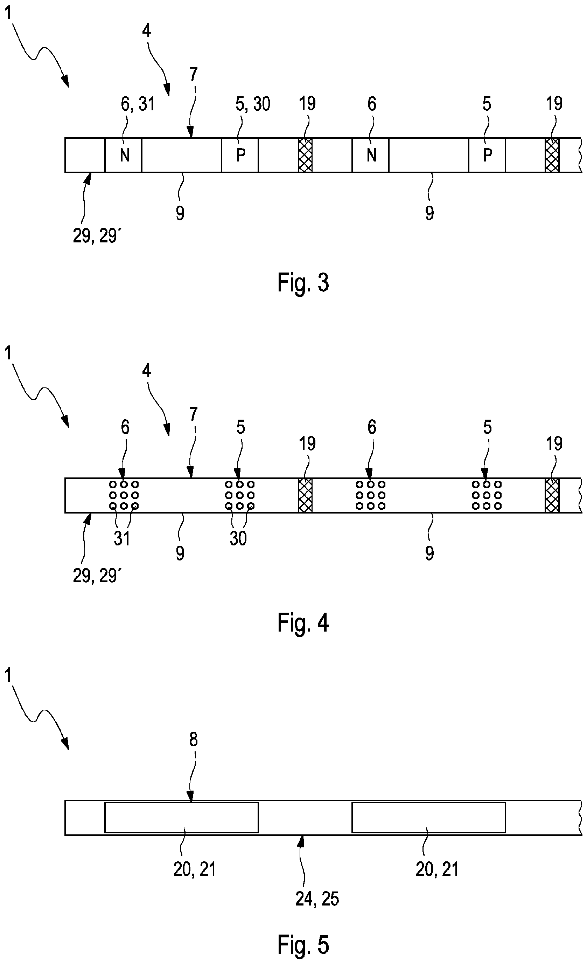

Fig. 3 zeigt einen Schnitt durch ein solches Peltier-Element 4, wobei lediglich die Halbleiter 5, 6 und die Verbindungsstruktur 7 zu sehen sind. Es ist erkennbar, dass dem jeweiligen Verbindungselement 9 ein solcher N-Halbleiter 6 und ein solcher P-Halbleiter 5 zugeordnet ist. Hierbei ist es vorstellbar, die Verbindungsstruktur 7 bzw. die Verbindungselemente 9 aus einem Band 29, insbesondere aus einem Endlosband 29', herzustellen, wobei besagtes Band 29 in entsprechenden Abschnitten mit den Halbleitern 5, 6 bestückt und in die jeweilige Verbindungselemente 9 getrennt wird. In den Bereichen der Trennung wird anschließend ein solcher Isolierabschnitt 19 vorgesehen. Anschließend kann ein Umformen des Bands 29 und ein Trennen des Bands 29, beispielsweise in den Fig. 1 und 2 gezeigten Ausführungsbespiele, erfolgen.

Vorstellbar ist es jedoch auch, die Verbindungselemente 9 nach dem Trennen und Umformen des Endlosbandes 29' mit den zugehörigen Halbleitern 5, 6 zu versehen.

Zur Realisierung der elektrischen seriellen Anordnung der Halbleiter 5, 6 kann eine entsprechende elektrische Unterbrechung des Bandes 29 erfolgen. Hierzu kann das Band 29 zunächst mit nicht sichtbaren Aussparungen oder Unterbrechungen versehen werden. In diesen Unterbrechungen können dann wahlweise besagte Isolierabschnitte vorgesehen werden.

Das Versehen der Halbleiter 5, 6 erfolgt hierbei vorzugsweise durch das Verlöten der Halbleiter 5, 6 mit dem Band 29 bzw. den Verbindungselementen 9. Vorstellbar ist es auch, die Halbleiter 5, 6 zunächst auf einen nicht gezeigten Träger aufzubringen, insbesondere den Träger mit den Halbleitern 5, 6 zu beschichten, und die mit den Halbleitern 5, 6 versehenen Träger mit den Band 29 bzw. mit den zugehörigen Verbindungselementen 9 zu verbinden.

Beim in Fig. 3 gezeigten Ausführungsbeispiel weist der jeweilige Halbleiter 5, 6 ein einziges Halbleiterelement 30, 31 auf. Das heißt, dass der P-Halbleiter 5 ein p-dotiertes P-Halbleiterelement 30 ist, wohingegen der N-Halbleiter 6 ein n-dotiertes N-Halbleiterelement 31 ist.

Fig. 4 zeigt ein anderes Ausführungsbeispiel des Peltier-Elements 4, der sich von dem in Fig. 3 gezeigten Ausführungsbeispiel im Wesentlichen dadurch unterscheidet, dass der jeweilige Halbleiter 5, 6 mehrere solche gleichartig dotierte Halbleiterelemente 30, 31 aufweist. Das heißt, dass der jeweilige P-Halbleiterelement 5 mehrere, im gezeigten Beispiel neun, p-dotierte P-Halbleiterelemente 30 aufweist, während der jeweilige N-Halbleiter 6 mehrere, im gezeigten Beispiel neun, N-Halbleiterelemente 31 aufweist.

Fig. 5 zeigt einen Schnitt durch den Wärmetauscher 1, bei dem eine Draufsicht auf den Fluidkanal 24 mit der Kontaktierungsstruktur 8 zu sehen ist. Wie aus Fig. 5 hervorgeht, ist der Fluidkanal 24 mit den Kontaktelementen 20 der Kontaktierungsstruktur 8 versehen, das heißt, dass die Kontaktelemente 20 auf den Fluidkanal 24 angebracht und/oder befestigt werden, wobei zwischen den Kontaktelementen 20 und dem Fluidkanal 24 bei Bedarf eine solche Isolierschicht 26 vorgesehen werden kann. Das Versehen des Fluidkanals 24 mit den Kontaktelementen 20 erfolgt beispielsweise durch ein Verkleben der Kontaktelemente 20 am Fluidkanal 24. Das Peltier-Element 4 kann dabei dadurch hergestellt werden, dass die mit den Halbleitern 5, 6 bestückte Verbindungsstruktur 7 mit den Kontaktelementen 20 und somit der Kontaktstruktur 8 verbunden werden, in dem die Halbleiter 5, 6 mit zugehörigen Kontaktelementen 20 elektrisch kontaktiert, insbesondere mit dem zugehörigen Kontaktelement 20 verlötet werden.

Selbstverständlich ist es auch vorstellbar, die Halbleiter 5, 6 zunächst auf die Kontaktelemente 20 anzubringen und mit diesen zu kontaktieren und anschließend einen elektrischen Kontakt zwischen den Halbleitern 5, 6 und den zugehörigen Verbindungselementen 9 herzustellen und aneinander zu befestigen, insbesondere zu verlöten.

## Patentansprüche

1. Verfahren zum Herstellen eines Peltier-Elements (4) eines Wärmetauschers (1) zum Temperieren eines Fluids, der einen vom zu temperierenden Fluid durchströmbaren Strömungsraum (3) aufweist, wobei
- das Peltier-Elements (4) eine Vielzahl von abwechselnd angeordneten p-dotierten P-Halbleitern (5) und n-dotierten N-Halbleitern (6) aufweist,
- wobei die Halbleiter (5, 6) auf ihrer dem Strömungsraum (3) zugewandten Seite durch eine Verbindungsstruktur (7) elektrisch kontaktiert sind, die jeweils zwei solche Halbleiter (5, 6) elektrisch kontaktierende Verbindungselemente (9) aufweist,
- wobei die Verbindungselemente (9) gegeneinander elektrisch isoliert sind,
- wobei die Halbleiter (5, 6) auf ihrer vom Strömungsraum (3) abgewandten Seite durch eine Kontaktierungsstruktur (8) elektrisch kontaktiert sind, die jeweils zwei solche Halbleiter (5, 6) elektrisch kontaktierende Kontaktelemente (20) aufweist,
- wobei die Kontaktelemente (20) gegeneinander elektrisch isoliert sind,
- wobei zumindest ein solches Verbindungselement (9) im Strömungsraum (3) angeordnet ist,
**gekennzeichnet durch** die Verfahrensschritte:
- Bereitstellen eines elektrisch leitenden Bandes (29),
- Abwechselndes Versehen des Bandes (29) mit p-dotierten P-Halbleitern (5) und n-dotierten N-Halbleitern (6) entlang des Bandes (29),
- Trennen des Bands (29) zum Herstellen der gegeneinander elektrisch isolierten Verbindungselemente (9).

2. Verfahren nach Anspruch 1,
**dadurch gekennzeichnet,**
**dass** das Band (29) nach dem Versehen mit den Halbleitern (5, 6) oder vor dem Versehen mit den Halbleitern (5, 6) umgeformt wird.

3. Thermoelektrischer Wärmetauscher (1) zum Temperieren eines Fluids, insbesondere für ein Kraftfahrzeug (2),
- mit einem vom zu temperierenden Fluid durchströmbaren Strömungsraum (3),
- mit einem Peltier-Element (4), das gemäß dem Verfahren nach Anspruch 1 oder 2 hergestellt ist,
- wobei zumindest ein solches Verbindungselement (9) im Strömungsraum (3) angeordnet ist.

4. Wärmetauscher nach Anspruch 3,
**dadurch gekennzeichnet,**
- **dass** der Wärmetauscher (1) einen von einem Temperierfluid durchströmbaren Fluidkanal (24) aufweist, der fluidisch vom Strömungsraum (3) getrennt und auf der vom Strömungsraum (3) abgewandten Seite der Halbleiter (5. 6) angeordnet ist, und/oder
- **dass** wenigstens ein solches Verbindungselement (9) in den Strömungsraum (3) absteht.

5. Wärmetauscher nach Anspruch 3 oder 4,
**dadurch gekennzeichnet,**
**dass** zumindest ein solches Verbindungselement (9) vom zu temperierenden Fluid durchströmbar ist.

6. Wärmetauscher nach einem der Ansprüche 3 bis 5,
**dadurch gekennzeichnet,**
- **dass** zumindest ein solches Verbindungselement (9) als ein Wärmeaustauschelement (15) zwischen dem Fluid und den zugehörigen Halbleitern (5, 6) ausgebildet ist, und/oder
- **dass** zumindest ein solches Verbindungselement (9) als eine in den Strömungsraum (3) abstehende Rippe (12) ausgebildet ist.

7. Wärmetauscher nach einem der Ansprüche 3 bis 6,
**dadurch gekennzeichnet,**
**dass** zumindest ein solches Verbindungselement (9) an zumindest einem der zugehörigen Halbleiter (5, 6) flächig anliegt.

8. Wärmetauscher nach einem der Ansprüche 3 bis 7,
**dadurch gekennzeichnet,**
**dass** zumindest zwei solche Verbindungelemente (9) voneinander beabstandet angeordnet und somit gegeneinander elektrisch isoliert sind.

9. Wärmetauscher nach einem der Ansprüche 3 bis 8,
**dadurch gekennzeichnet,**
**dass** zumindest zwei solche Verbindungselemente (9) über einen elektrisch isolierenden Isolierabschnitt (19) mechanisch miteinander verbunden sind.

10. Wärmetauscher nach Anspruch 9,
**dadurch gekennzeichnet,**
**dass** der Isolierabschnitt (19) zum Ausgleich thermischer Spannungen elastisch ausgebildet ist.

11. Wärmetauscher nach einer der Ansprüche 3 bis 10,
**dadurch gekennzeichnet,**
**dass** wenigstens ein solches Verbindungselement (9) zum Ausgleich thermischer Spannungen elastisch ausgebildet ist.

12. Wärmetauscher nach einem der Ansprüche 4 bis 11,
**dadurch gekennzeichnet,**
**dass** zumindest ein solches Kontaktelement (20) auf der dem Strömungsraum (3) zugewandten Seite des Fluidkanals (24) angeordnet und am Fluidkanal (24) befestigt ist.

13. Wärmetauscher nach Anspruch 12,
**dadurch gekennzeichnet,**
**dass** zwischen einem solchen am Fluidkanal (24) befestigten Kontaktelement (20) und dem Fluidkanal (24) eine elektrisch isolierende Isolierschicht (26) angeordnet ist.

14. Wärmetauscher nach einem der Ansprüche 3 bis 13,
**dadurch gekennzeichnet,**
**dass** der Wärmetauscher (1) zumindest zwei solche Peltier-Elemente (4) aufweist.

15. Wärmetauscher nach einem der Ansprüche 3 bis 14,
**dadurch gekennzeichnet,**
**dass** zumindest ein solcher Halbleiter (5, 6) wenigstens zwei gleichartig dotierte Halbleiterelemente (30, 31) aufweist.

## Claims

1. Method for producing a Peltier element (4) of a heat exchanger (1) for regulating the temperature of a fluid, which has a flow chamber (3) through which a fluid, the temperature of which is to be regulated, can flow, wherein
- the Peltier element (4) has a plurality of alternately arranged p-doped P-semiconductors (5) and n-doped N-semiconductors (6),
- wherein the semiconductors (5, 6) are electrically contacted on their side facing the flow chamber (3) by a connecting structure (7) which has connecting elements (9) electrically contacting two such semiconductors (5, 6),
- wherein the connecting elements (9) are electrically insulated from one another,
- wherein the semiconductors (5, 6) are contacted electrically on their side facing away from the flow chamber (3) by a contacting structure (8), which has contact elements (20) electrically contacting two such semiconductors (5, 6),
- wherein the contact elements (20) are electrically insulated from one another,
- wherein at least one such connecting element (9) is arranged in the flow chamber (3),
**characterised by** the method steps:
- providing an electroconductive band (29),
- alternately providing the band (29) with p-doped P-semiconductors (5) and n-doped N-semiconductors (6) along the band (29),
- separating the band (29) to produce the electrically insulated connecting elements (9).

2. Method according to claim 1,
**characterised in that** the band (29) is shaped after being provided with the semiconductors (5, 6) or before being provided with the semiconductors (5, 6).

3. Thermoelectric heat exchanger (1) for controlling the temperature of a fluid, in particular for a motor vehicle (2) comprising:
- a flow chamber (3) flowed through by a fluid, the temperature of which is to be regulated,
- a Peltier element (4), which is produced according to the method according to claim 1 or 2,
- wherein at least one such connecting element (9) is arranged in the flow chamber (3).

4. Heat exchanger according to claim 3,
**characterised in that**
- the heat exchanger (1) has a fluid channel (24) through which a fluid, the temperature of which is to be regulated, can flow, which is fluidically separated from the flow chamber (3) and is arranged on the side of the semiconductors (5, 6) facing away from the flow chamber (3), and/or
- at least one such connecting element (9) projects into the flow chamber (3).

5. Heat exchanger according to claim 3 or 4,
**characterised in that**
at least one such connecting element (9) can be flowed through by the fluid, the temperature of which is to be regulated.

6. Heat exchanger according to any of claims 3 to 5,
**characterised in that**,
- at least one such connecting element (9) is designed as a heat exchange element (15) between the fluid and the associated semiconductors (5, 6), and/or
- at least one such connecting element (9) is designed as a rib (12) that protrudes into the flow chamber (3).

7. Heat exchanger according to any of claims 3 to 6,
**characterised in that**
at least one such connecting element (9) bears flat on at least one of the respective semiconductors (5, 6).

8. Heat exchanger according to any of claims 3 to 7,
**characterised in that**
at least two such connecting elements (9) are arranged to be spaced apart from one another and are electrically insulated from one another.

9. Heat exchanger according to any of claims 3 to 8,
**characterised in that**
at least two such connecting elements (9) are joined to one another mechanically via an electrically insulating section (19).

10. Heat exchanger according to claim 9,
**characterised in that**
the insulating section (19) is designed to be elastic for compensating for thermal stresses.

11. Heat exchanger according to any of claims 3 to 10,
**characterised in that**
at least one such connecting element (9) is designed to be elastic for compensating for thermal stresses.

12. Heat exchanger according to any of claims 4 to 11,
**characterised in that**
at least one such contact element (20) is arranged on the side of the fluid channel (24) facing the flow chamber (3) and is secured to the fluid channel (24).

13. Heat exchanger according to claim 12,
**characterised in that**
an electrically insulating insulating layer (26) is arranged between one such contact element (20) secured to the fluid channel (24) and the fluid channel (24).

14. Heat exchanger according to any of claims 3 to 13,
**characterised in that**
the heat exchanger (1) has at least two such Peltier elements (4).

15. Heat exchanger according to any of claims 3 to 14,
**characterised in that**
at least one such semiconductor (5, 6) has at least two identically doped semiconductor elements (30, 31).

## Revendications

1. Procédé de production d'un élément à effet Peltier (4) d'un échangeur de chaleur (1) pour la régulation de température d'un fluide, qui présente un espace de circulation (3) pouvant être parcouru par le fluide à réguler en température, dans lequel
- l'élément à effet Peltier (4) présente une pluralité de semi-conducteurs de type P (5) à dopage p et de semi-conducteurs de type N (6) à dopage n, agencés de manière alternée,
- dans lequel les semi-conducteurs (5, 6) sont mis en contact électrique sur leur face tournée vers l'espace de circulation (3) grâce à une structure de liaison (7) qui présente des éléments de liaison (9) mettant en contact électrique respectivement deux semi-conducteurs (5, 6) desdits types,
- dans lequel les éléments de liaison (9) sont isolés électriquement les uns des autres,
- dans lequel les semi-conducteurs (5, 6) sont mis en contact électrique sur leur face détournée de l'espace de circulation (3) grâce à une structure de contact (8) qui présente des éléments de contact (20) mettant en contact électrique respectivement deux semi-conducteurs (5, 6) desdits types,
- dans lequel les éléments de contact (20) sont isolés électriquement les uns des autres,
- dans lequel au moins un élément de liaison (9) dudit type est agencé dans l'espace de circulation (3),
**caractérisé par** les étapes de procédé consistant à :
- fournir une bande électriquement conductrice (29),
- munir de manière alternée la bande (29) de semi-conducteurs de type P (5) à dopage p et de semi-conducteurs de type N (6) à dopage n le long de la bande (29),
- découper la bande (29) afin de produire les éléments de liaison (9) isolés électriquement les uns des autres.

2. Procédé selon la revendication 1,
**caractérisé en ce que**
la bande (29) est transformée après avoir été munie des semi-conducteurs (5, 6) ou avant d'avoir été munie des semi-conducteurs (5, 6).

3. Échangeur de chaleur thermoélectrique (1) pour la régulation de température d'un fluide, en particulier pour un véhicule automobile (2),
- avec un espace de circulation (3) pouvant être parcouru par le fluide à réguler en température,
- avec un élément à effet Peltier (4) produit conformément au procédé selon la revendication 1 ou 2,
- dans lequel au moins un élément de liaison (9) dudit type est agencé dans l'espace de circulation (3).

4. Échangeur de chaleur selon la revendication 3,
**caractérisé en ce que**
- l'échangeur de chaleur (1) présente un canal de fluide (24) pouvant être parcouru par un fluide à réguler en température, séparé fluidiquement de l'espace de circulation (3) et agencé du côté des semi-conducteurs (5, 6) qui est détourné de l'espace de circulation (3), et/ou
- au moins un élément de liaison (9) dudit type fait saillie dans l'espace de circulation (3).

5. Échangeur de chaleur selon la revendication 3 ou 4,
**caractérisé en ce que**
au moins un élément de liaison (9) dudit type peut être parcouru par le fluide à réguler en température.

6. Échangeur de chaleur selon l'une quelconque des revendications 3 à 5,
**caractérisé en ce que**
- au moins un élément de liaison (9) dudit type est réalisé sous forme d'un élément d'échange thermique (15) entre le fluide et les semi-conducteurs (5, 6) associés, et/ou
- au moins un élément de liaison (9) dudit type est réalisé sous forme d'une nervure (12) faisant saillie dans l'espace de circulation (3).

7. Échangeur de chaleur selon l'une quelconque des revendications 3 à 6,
**caractérisé en ce que**
au moins un élément de liaison (9) dudit type repose à plat sur au moins un des semi-conducteurs (5, 6) associés.

8. Échangeur de chaleur selon l'une quelconque des revendications 3 à 7,
**caractérisé en ce que**
au moins deux desdits éléments de liaison (9) sont agencés à distance l'un de l'autre et sont ainsi isolés électriquement l'un de l'autre.

9. Échangeur de chaleur selon l'une quelconque des revendications 3 à 8,
**caractérisé en ce que**
au moins deux desdits éléments de liaison (9) sont reliés mécaniquement l'un à l'autre par l'intermédiaire d'une section isolante (19) électriquement isolante.

10. Échangeur de chaleur selon la revendication 9,
**caractérisé en ce que**
la section isolante (19) est réalisée de manière élastique pour compenser des contraintes thermiques.

11. Échangeur de chaleur selon l'une quelconque des revendications 3 à 10,
**caractérisé en ce que**
au moins un élément de liaison (9) dudit type est réalisé de manière élastique pour compenser des contraintes thermiques.

12. Échangeur de chaleur selon l'une quelconque des revendications 4 à 11,
**caractérisé en ce que**
au moins un élément de contact (20) dudit type est agencé du côté du canal de fluide (24) qui est tourné vers l'espace de circulation (3), et est fixé au canal de fluide (24).

13. Échangeur de chaleur selon la revendication 12,
**caractérisé en ce que**
une couche isolante (26) électriquement isolante est agencée entre un élément de contact (20) dudit type fixé au canal de fluide (24) et le canal de fluide (24).

14. Échangeur de chaleur selon l'une quelconque des revendications 3 à 13,
**caractérisé en ce que**
l'échangeur de chaleur (1) présente au moins deux desdits éléments à effet Peltier (4).

15. Échangeur de chaleur selon l'une quelconque des revendications 3 à 14,
**caractérisé en ce que**
au moins un semi-conducteur (5, 6) dudit type présente au moins deux éléments semi-conducteurs (30, 31) dopés de manière identique.
